# FASCICULE DE BREVET EUROPEEN

(11) **EP 0 614 958 B1**
(45) Date de publication et mention de la délivrance du brevet: **03.06.1998**
(21) Numéro de dépôt: 94420079.9
(22) Date de dépôt: 09.03.1994
(51) Int. Cl.: C09D 183/06, C08K 5/00, C08G 85/00

(54) **Compositions à base de polyorganosiloxanes réticulables par voie cationique et leur utilisation dans le domaine de l'antiadhérence papier, de la protection des fibres optiques et des circuits imprimés**
Kationisch vernetzbare Polyorganosiloxanzusammensetzungen und deren Anwendung zur Haftverminderung von Papier, zum Schutz von optischen Fasern und von integrierten Schaltkreisen
Cationic cross-linkable polyorganosiloxane compositions, their use as anti-adherents for paper and for protecting optical fibers and integrated circuits

(30) Priorité: 10.03.1993 FR 9302749
(43) Date de publication de la demande: 14.09.1994
(73) Titulaire: RHODIA CHIMIE, 92408 Courbevoie Cédex (FR)
(72) Inventeur: Priou, Christian, F-69100 Villeurbanne (FR)
(74) Mandataire: Trolliet, Maurice

(56) Documents cités:
- EP-A- 0 126 712
- EP-A- 0 306 161
- EP-A- 0 449 027
- EP-A- 0 468 651
- EP-A- 0 562 897
- GB-A- 2 084 598
- Chem. & Eng. News, 63(5)26-27,1985

## Description

La présente invention a pour objet les compositions à base de polyorganosiloxanes à groupements fonctionnels de type époxy réticulables par voie cationique, leur utilisation en couche mince pour la réalisation de revêtements antiadhésifs ou en couche épaisse pour le gainage des fibres optiques ou la protection de circuits imprimés en électronique, ainsi que les articles constitués d'un support solide dont une surface au moins est rendue antiadhésive par revêtement à l'aide desdits polyorganosiloxanes fonctionnels réticulés par activation photochimique ou sous faisceau d'électrons.

Il est connu d'utiliser des perfluorotétraphénylborates de ferrocénium du type bis(η⁵-cydopentadiényle) Fe⁺ tétrakis(pentafluoroborate) pour engendrer des catalyseurs du type Ziegler-Natta, catalyseurs qui sont ensuite mis en oeuvre pour polymériser des monomères vinyliques (demandes de brevets EP-A-481.480 ; EP-A-468.651 ; EP-A-418.044 ; EP-A-468.537 ; EP-A-421.659 ; EP-A-277.004 ; Makromol. Chem., Rapid Commun. 12, 663-667, 1991 ; Organometallics 1991, 10, 840-842) ; on a constaté que les perfluorotétraphénylborates de ferrocénium du type tétrakis(pentafluorophénylborate) de bis(η⁵-cyclopentadiényle) Fe⁺ ne sont pas des photoamorceurs.

Il est également connu d'utiliser par exemple des photoamorceurs du type (η⁵-cyclopentadienyl)tricarbonyl Fe⁺ PF₆⁻ (η⁵-cydopentadienyl)carbonylbis(triphénylstibine)Fe+ , PF₆⁻ bis(η⁶-mesitylene)Fe⁺⁺ , bisSbF₆⁻ (η⁵-cyclopentadienyl)dicarbonylmethylisonitrileFe⁺ , AsF₆⁻, supportés sur notamment de la silice ou de la cellulose végétale, pour polymériser ou réticuler par voie cationique des monomères ou des polymères à fonctions époxy (cf. EP-A-203.829). On a constaté que ces amorceurs dont l'entité anionique est choisie parmi AsF₆⁻, SbF₆⁻, PF₆⁻ ne sont pas ou que peu efficaces pour réticuler les silicones par voie cationique.

Il existe un autre type de photoamorceurs ayant une structure bien différente consistant dans des sels d'onium dont l'anion est choisi parmi BF₄⁻, PF₆⁻, AsF₆⁻, SbF₆⁻, SbCl₆⁻, HSO₄⁻, ClO₄-(cf. EP-A-449.027).

Les compositions de l'invention sont à base
- d'un polyorganosiloxane présentant des groupements fonctionnels de type époxy, réticulable par voie cationique, ledit polyorganosiloxane étant linéaire ou sensiblement linéaire et constitué de motifs de formule (II) et terminé par des motifs de formule (III) ou cyclique constitué de motifs de formule (II) 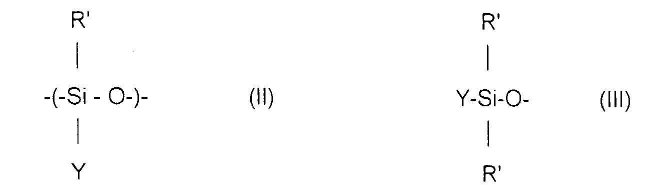 formules dans lesquelles
   . les symboles R' sont semblables ou différents et représentent un radical alkyle linéaire ou ramifié en C₁ - C₆, éventuellement substitué, cycloalkyle en C₅ - C₈, aryle, aryle substitué, au moins 60 % molaire des radicaux R' étant des radicaux méthyles ;
   . les symboles Y sont semblables ou différents et représentent soit le groupement R' soit un radical organique époxy fonctionnel réticulable par voie cationique, chaque fonction époxy étant reliée à un atome de la chaîne silicone par l'intermédiaire d'un radical divalent contenant de 2 à 20 atomes de carbone ;
   l'un au moins des symboles Y représentant un radical organique époxy fonctionnel réticulable par voie cationique, et
- d'une quantité catalytique efficace d'un borate d'un complexe organométallique ; elles sont caractérisées en ce que l'entité cationique dudit borate de complexe organométallique est choisie parmi les sels organométalliques de formule

   (L¹ L²L³M)^{+q} (I)

   formule dans laquelle :
   . M représente un métal choisi parmi du fer, manganèse, chrome et cobalt,
   . L¹ représente 1 ligand lié au métal M par des électrons π, ligand choisi parmi les ligands η³-alkyl, η⁵-cyclopentadiènyl et η⁷-cycloheptatriènyl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 3 à 8 électrons π ;
   . L² représente 1 ligand lié au métal M par des électrons π, ligand choisi parmi les ligands η⁷-cycloheptatriènyl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 6 ou 7 électrons π ;
   . L³ représente de 0 à 3 ligands identiques ou différents liés au métal M par des électrons σ, ligand(s) choisi(s) parmi CO et NO₂⁺ ;
   la charge électronique totale q du complexe à laquelle contribuent L¹, L² et L³ et la charge ionique du métal M étant positive et égale à 1 ou 2 ;
   et en ce que l'entité anionique borate a pour formule :

   [B Xₐ R_{b}]⁻

   formule dans laquelle :
   - a et b sont des nombres entiers allant de 0 à 4 avec a + b = 4
   - les symboles X représentent
      . un atome d'halogène (chlore, fluor) avec a = 0 à 3
      . une fonction OH avec a = 0 à 2
   - les symboles R sont identiques ou différents et représentent
      . un radical phényle substitué par au moins un élément ou un groupement électroattracteur choisi parmi un atome d'halogène (fluor tout particulièrement), CF₃, NO₂, CN,
      . un radical aryle contenant au moins deux noyaux aromatiques tel que par exemple biphényle, naphtyle, éventuellement substitué par au moins un élément ou un groupement électroattracteur choisi parmi un atome d'halogène (fluor tout particulièrement), CF₃, NO₂, CN.

Comme exemple d'anion borate on peut citer :
[B (C₆F₅)₄]⁻ ; [B (C₆H₄CF₃)₄]⁻ ;
[(C₆F₅)₂ B F₂]⁻ ; [C₆F₅ B F₃]⁻ ; [B (C₆H₃F₂)₄]⁻.

Les sels organométalliques de formule (I) figurent parmi ceux décrits dans les brevets US-A-4.973.722 ; US-A-4.992.572, les demandes de brevet européen EP-A-203.829 ; EP-A-323.584 et EP-A-354.181.

Parmi ces sels organometalliques on peut citer tout particulièrement :
. le (η⁵-cyclopentadiènyle) (η⁶-toluène) Fe⁺ ;
. le (η⁵-cyclopentadiènyle) (η⁶-méthyl1-naphtalène) Fe⁺ ;
. le (η⁵-cyclopentadiènyle) (η⁶-cumène) Fe⁺ ;
. le bis (η⁶-mesitylène) Fe⁺ ;
. le bis (η⁶-benzène)Cr⁺.

Comme exemple de borates amorceurs , on peut citer :
. le (η⁵-cyclopentadiènyle) (η⁶-toluène) Fe⁺, [B (C6F5)₄]⁻;
. le (η⁵-cyclopentadiènyle) (η⁶-méthyl1-naphtalène) Fe⁺, [B (C₆F₅)₄]- ;
. le (η⁵-cyclopentadiènyle) (η⁶cumène)Fe⁺, [B (C₆ F₅)₄]⁻.

Lesdits borates amorceurs peuvent être préparés par réaction d'échange entre un sel de l'entité cationique (halogénure tel que par exemple chlorure, bromure, hexafluorophosphate, tetrafluoroborate) avec un sel de métal alcalin (sodium, lithium, potassium) de l'entité anionique.

Les conditions opératoires (notamment quantités respectives de réactifs, choix des solvants, durée, température, agitation) sont à la portée de l'homme de l'art ; celles-ci doivent permettre de récupérer le sel amorceur recherché sous forme solide par filtration du précipité formé.

Les sels de métal alcalin de l'entité anionique peuvent être préparés de manière connue, par réaction d'échange entre un composé halogénoboré et un composé organométallique (par exemple magnésien, lithien, stannique) portant les groupements hydrocarbonés désirés, en quantité stoechiométrique, suivie éventuellement d'une hydrolyse à l'aide d'une solution aqueuse d'halogénure de métal alcalin ; ce type de synthèse est par exemple décrite dans "J. of organometallic Chemistry" vol 178, p.1-4, 1979 ; "J.A.C.S" 82, 1960, 5298 ; "Anal.Chem,Acta" 44, 1969, 175-183 ; brevets US-A- 4.139.681 et DE-A-2.901.367 ; "Zh. Org. Khim." Vol.25, N°5- - pages 1099-1102 Mai 1989.

Le mode préparatoire des sels de l'entité cationique est décrit notamment dans D. ASTRUC , Tetrahedron Letters, 36, p. 3437 (1973) ; D. ASTRUC, Bull. Soc. Chim. Fr., 1-2, p. 228 (1976) ; D. ASTRUC, Bull. Soc. Chim. Fr., 11-12, p. 2571 (1975) ; D. ASTRUC, CR Acad.Sc. Paris, serie C, 272, p. 1337 (1971) ; A.N. NESMEYANOV et coll., Izves. Akad. Nauk SSSR, ser.Khim., 7, p. 1524 (1969) ; A.N. NESMEYANOV et coll., Dokl. Akad. Nauk SSSR, 160(6), p. 1327 (1965) ; A.N. NESMEYANOV et coll., Dokl. Akad. Nauk SSSR, 149(3), p. 615 (1963).

Les polyorganosiloxanes époxyfonctionnels réticulables par voie cationique entrant dans la composition de l'invention présentent de préférence de 1 à 10 radicaux organiques époxyfonctionnels par mole de polymère.

Les polyorganosiloxanes époxy sont décrits notamment dans les brevets DE-A-4.009.889 ; EP-A-396.130 ; EP-A-355.381 ; EP-A-105.341 ; FR-A-2.110.115 ; FR-A-2.526.800.

Les polyorganosiloxanes époxy fonctionnels peuvent être préparés par réaction d'hydrosilylation entre des huiles à motifs Si-H et des composés époxyfonctionnels tels que par exemple le vinyl-4 cyclohexèneoxyde, l'allylglycidyléther.

Les polyorganosiloxanes époxyfonctionnels se présentent généralement sous forme de fluides présentant une viscosité à 25°C de 10 à 10.000 mm²/s et de préférence de 100 à 600 mm²/s.

Par quantité catalytique efficace de borate de complexe organométallique, on entend selon l'invention, la quantité suffisante pour amorcer la réticulation ; cette quantité est généralement comprise entre 0,01 et 20 parties en poids, le plus souvent entre 0,1 et 8 parties en poids pour réticuler par voie photochimique 100 parties en poids de polyorganosiloxane réticulable.

Les compositions selon l'invention peuvent comporter en outre d'autres ingrédients tels que par exemple des modulateurs d'adhérence (résines ou polymères linéaires silicones portant par exemple des fonctions vinyle, époxy, vinyléther, alcool), des pigments, des photosensibilisateurs, des agents fongicides, bactéricides et anti-microbiens, des inhibiteurs de corrosion.

Les compositions selon l'invention sont utilisables telles quelles ou en solution dans un solvant organique. Elles sont utiles en couche mince dans le domaine des revêtements anti-adhérents sur les matériaux cellulosiques, les peintures, ainsi qu'en couche épaisse pour l'encapsulation de composants électriques et électroniques, les revêtements pour textiles, ainsi que pour le gainage de fibres optiques.

Elles sont tout particulièrement intéressantes lorsqu'elles sont utilisées telles quelles pour rendre non adhérent un matériau , tel que des feuilles métalliques, du verre, des matières plastiques ou du papier, à d'autres matériaux auquels il adhérerait normalement. La composition présente avantageusement une viscosité ne dépassant pas 5 000 mPa.s, de préférence ne dépassant pas 4 000 mPa.s à 25°C.

L'invention vise donc également un procédé permettant de rendre des articles (feuilles par exemple) non adhérents à des surfaces auxquelles ils adhèrent normalement, procédé caractérisé en ce qu'il consiste à appliquer une quantité de composition de l'invention, comprise généralement entre 0,1 et 5 g par m² de surface à enduire et à réticuler la composition par apport d'énergie dont au moins une partie, de préférence la totalité, est fournie par un rayonnement U.V.

Le rayonnement U.V. utilisé présente une longueur d'onde comprise entre 200 et 400 nanomètres, de préférence comprise entre 254 et 360 nanomètres.

La durée d'irradiation peut être courte et elle est généralement inférieure à 1 seconde et est de l'ordre de quelques centièmes de seconde pour les faibles épaisseurs de revêtement. La réticulation effectuée est excellente même en l'absence de tout chauffage. Bien entendu un chauffage entre 25 et 100°C n'est pas exclu de l'invention.

Bien entendu, on peut régler le temps de durcissement notamment, par le nombre de lampes U.V. utilisées, par la durée d'exposition aux U.V. et par la distance entre la composition et la lampe U.V.

Les compositions sans solvant, c'est-à-dire non diluées, sont appliquées à l'aide de dispositifs aptes à déposer, d'une façon uniforme, de faibles quantités de liquides. On peut utiliser à cet effet par exemple le dispositif nommé "Helio glissant" comportant en particulier deux cylindres superposés : le rôle du cylindre placé le plus bas, plongeant dans le bac d'enduction où se trouve la composition, est d'imprégner en une couche très mince le cylindre placé le plus haut, le rôle de ce dernier est alors de déposer sur le papier les quantités désirées de composition dont il est imprégné, un tel dosage est obtenu par réglage de la vitesse respective des deux cylindres qui tournent en sens inverse l'un de l'autre.

Les quantités de compositions déposées sur les supports sont variables et s'échelonnent le plus souvent entre 0,1 et 5 g/m² de surface traitée. Ces quantités dépendent de la nature des supports et des propriétés antiadhérentes recherchées. Elles sont plus souvent comprises entre 0,5 et 1,5 g/m² pour des supports non poreux.

Les compositions, de l'invention peuvent également être utilisées en couches plus épaisses (> 5 micromètres), comme vernis de tropicalisation ("comformal coating"), vernis dont le rôle est d'isoler électriquement les composants et les circuits d'un assemblage, ainsi que de les maintenir à l'abri de l'environnement extérieur ét des facteurs mécaniques pouvant compromettre la performance de l'ensemble. Lesdites compositions peuvent alors être appliquées par pulvérisation ou par trempage, ou encore par brossage ; les épaisseurs de composition déposées dépendent du mode d'application choisi et varient le plus souvent de 5 micromètres à quelques dixièmes de millimètres ; une étape de polymérisation ultérieure peut dans certains cas être nécessaire ; celle-ci peut être accomplie par un traitement thermique.

La présente invention a également pour objet les articles (feuilles par exemple) constitués d'un matériau solide (par exemple métal, verre, matière plastique, papier) dont une surface au moins est revêtue de la composition ci-dessus décrite photoréticulée ou réticulée sous faisceau d'electrons.

Les exemples suivants sont donnés à titre illustratif et ne peuvent être considérés comme une limite du domaine de l'invention.

### Exemple 1: . le (η⁵-cyclopentadiènyle) (η⁶-toluène) Fe⁺ tetrakis (pentafluorophényl)borate- "(η⁵cp)(η⁶t)Fe⁺, B(C₆F₅)₄^{-"} -

Dans un ballon tricol de 250 ml contenant 7 g de tétrakis(pentafluorophényl) borate de sodium dissous dans 100 ml d'eau distillée, on ajoute 50 ml d'une solution aqueuse contenant 3,58 g de (η⁵-cyclopentadiènyle) (η⁶-toluène) Fe⁺ hexafluorophosphate. Le mélange est soumis pendant 1 heure à une agitation magnétique. Il se forme un précipité blanc que l'on sépare par filtration puis sèche sous vide pendant 24 heures. On obtient ainsi 8,5 g (soit un rendement de 95%) de (η⁵-cyclopentadiènyle)(η⁶-toluène) Fe⁺ tétrakis(pentafluorophényl) borate .
La formule du produit obtenu a été confirmée par RMN ¹H, ¹⁹F et par spectrométrie de masse.

### Exemple 2 : (η⁵-cyclopentadiènyle) (η⁶-méthyl1-naphtalène) Fe⁺ tetrakis (pentafluorophényl)borate - "(η⁵cp)(η⁶n) Fe⁺, B(C₆F₅)₄"

On procède comme à l'exemple 1, à partir de 7 g de tétrakis(pentafluorophényl) borate de sodium et de 3,5 g de (η⁵-cyclopentadiènyle) (η⁶-toluène) Fe⁺tétrafluoroborate ; on obtient 8,9 g du produit attendu.
La formule est confirmée par analyse RMN et par spectrométrie de masse.

### Exemple 3 : (η⁵-cyclopentadiènyle) (η⁶-cumène) Fe+ tetrakis (pentafluorophényl)borate - "(η⁵cp)(η⁶c) Fe⁺ , B(C₆F₅)₄⁻"

Dans un ballon tricol de 250 ml. équipé d'une agitation mécanique, d'un réfrigérant à eau, d'un thermomètre et d'une ampoule de coulée, on charge 4 g (soit 0,0215 mole) de ferrocène, 7,64 g de chlorure d'aluminium, 0,11 g d'aluminium en poudre et 27 g de cumène.
L'ensemble est agité et plaçé sous atmosphère inerte d'azote. On chauffe le mélange réactionnel en 2 heures, puis on ajoute goutte à goutte 4,04 g de chlorure de titane.L'ensemble est chauffé pendant 1 heure à 100 °C, puis on laisse revenir doucement le mélange à température ambiante. On verse le mélange réactionnel dans un mélange de 30 g de glace et de 8 g d'HCl à 37,5 % ; on laisse 30 min. sous agitation. On ajoute alors 0,7 g d'eau oxygénée ; on laisse 30 min. sous agitation, puis on filtre sur un verre fritté n°4. On récupère la fraction liquide ; après décantation et séparation des phases, on introduit à la phase aqueuse une solution de 15,4 g de tetrakis(pentafluorophényl)borate de potassium dans 800 ml d'eau ; l'ensemble est laissé sous agitation pendant 2 heures.
Le précipité est séparé par filtration, puis est séché sous vide ; on obtient 14,3 g (soit un rendement de 73 %) de produit recherché.

### Exemple 4: photoréticulation d'un organopolysiloxane époxydé en couche mince

Un bain est préparé selon le mode opératoire suivant :
- à 100 parties en poids d'un organopolysiloxane de formule M D^{E}₃ D₃₀ M , où M = (CH₃)₃SiO_{1/2} , D^{E} = (4 -éthylcyclohexéneoxyde)(CH₃)SiO_{2/2} et D = (CH₃)₂SiO_{2/2}, présentant une viscosité de 500 mPa.s. à 25°C, on ajoute
- x parties en poids de photoamorceur A en solution à 50 % en poids dans un l'acétone ou le butanol-1.
On agite vigoureusement le mélange à température ambiante pendant 30 minutes. On obtient une solution parfaitement limpide et légèrement colorée.
Le mélange est déposé (environ 2 à 3 g/m²) sur du papier glassine (Sibille ^{®} 9530 commercialisé par la société SIBILLE) au moyen d'une barre de MEYER ^{®} n°0 (commercialisée par la société ERICHSEN G-B).

Le papier enduit passe sous une lampe U.V. de technologie FUSION SYSTEM ^{®} F 450 (commercialisée par la société FUSION) et caractérisée par:
- une longueur d'onde de 360 nm,
- une absence d'électrodes,
- une excitation par micro-ondes,
- une puissance de 120 W par cm irradié,
L'énergie d'irradiation est mesurée avec une cellule UVICURE ^{®} de la société EIT-USA ; après un passage sous la lampe UV, on note la vitesse de défilement en m/min nécessaire au durcissement de la couche silicone.
Figurent au tableau 1 les vitesses de défilement du papier, avec les énergies d'irradiation correspondantes; les performances des amorceurs préparés aux exemples 1 à 3 sont comparées à celles d'un amorceur de cation équivalent mais dont l'anion est SbF₆⁻ ; on constate que ce dernier n'a aucune efficacité en réticulation en couche mince.

### Exemple 5 : photoréticulation d'un polyorganosiloxane époxydé en couche épaisse

La composition préparée selon le mode opératoire de l'exemple 4 est versée dans des moules de 1 cm de profondeur, puis est exposée sous une lampe UV de faible puissance (1,4 mW/cm²). On mesure le temps necessaire pour réticuler la composition sur toute l'épaisseur.
Les résultats figurent au tableau 2 et sont comparés à ceux obtenus avec des photoamorceurs cationiques de l'art antérieur.

### Exemple 6 comparatif : photoréticulation d'un polyorganosiloxane époxydé à l'aide de bis(η⁵-cyclopentadiényle) Fe⁺ tetrakis(pentafluorophényl)borate

On répète l'opération décrite à l'exemple 5, en remplaçant le photoamorceur par la même quantité de tetrakis(pentafluorophényl)borate de bis(η⁵-cyclopentadiényl)Fe⁺. Après 60 minutes d'exposition sous la lampe UV, on ne constate aucune réticulation.

**TABLEAU 1**

| **Photoamorceur A** | **x solvant** | **vitesse de défilement m/mn** | **energie d'irradiation J.cm**^{**-2**} |
|---|---|---|---|
| (η⁵cp)(η⁶c) Fe⁺ , B(C₆F₅)₄⁻ | 4 acetone | 15 | 0,048 |
| (η⁵cp)(η⁶t) Fe⁺ , B(C₆F₅)₄⁻ | 2 acetone | 5 | 0,20 |
| (η⁵cp)(η⁶t) Fe⁺ , B(C₆F₅)₄⁻ | 4 acetone | 15 | 0,048 |
| (η⁵cp)(η⁶t) Fe⁺ , B(C₆F₅)₄⁻ | 2 butanol-1 | 30 | 0,028 |
| (η⁵cp)(η⁶n) Fe⁺ , B(C₆F₅)₄⁻ | 2 acetone | 5 | 0,20 |
| (η⁵cp)(η⁶n) Fe⁺ , B(C₆F₅)₄⁻ | 2 butanol | 15 | 0,048 |
| (η⁵cp)(η⁶n) Fe⁺ , SbF₆⁻ | 5 acetone | 0 | >1,2 |

**TABLEAU 2**

| **Photoamorceur** | **x solvant** | **temps de réticulation** |
|---|---|---|
| (η⁵cp)(η⁶n) Fe⁺ , B(C₆F₅)₄⁻ | 2 méthanol | 7 mn 10 s |
| (η⁵cp)(η⁶c) Fe⁺ , B(C₆F₅)₄⁻ | 2 méthanol | 10 mn |
| (η⁵cp)(η⁶t) Fe⁺ , B(C₆F₅)₄⁻ | 2 sans solvant | 15 mn |
| (η⁵cp)(η⁶c) Fe⁺ , SbF₆⁻ | 2 méthanol | 20 mn |
| (η⁵cp)(η⁶n) Fe⁺ , PF₆⁻ | 2 méthanol | 30 mn |
| (η⁵cp)₂Fe⁺ , B(C₆F₅)₄⁻* | 2 méthanol | >40 mn |

| | | |
|---|---|---|
| * comparatif | | |

## Revendications

1. Compositions à base :
• d'un polyorganosiloxane présentant des groupements fonctionnels de type époxy, réticulable par voie cationique, ledit polyorganosiloxane étant linéaire ou sensiblement linéaire et constitué de motifs de formule (II) et terminé par des motifs de formule (III) ou cyclique constitué de motifs de formule (II) 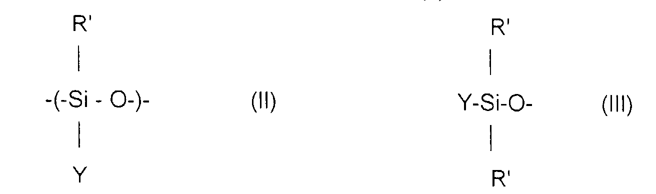 formules dans lesquelles
. les symboles R' sont semblables ou différents et représentent un radical alkyle linéaire ou ramifié en C₁ - C₆, éventuellement substitué, cycloalkyle en C₅ - C₈, aryle, aryle substitué, au moins 60 % molaire des radicaux R' étant des radicaux méthyles ;
. les symboles Y sont semblables ou différents et représentent soit le groupement R' soit un radical organique époxy fonctionnel réticulable par voie cationique, chaque fonction époxy étant reliée à un atome de la chaîne silicone par l'intermédiaire d'un radical divalent contenant de 2 à 20 atomes de carbone ;
l'un au moins des symboles Y représentant un radical organique époxy fonctionnel réticulable par voie cationique, et
• d'une quantité catalytique efficace d'un borate d'un complexe organométallique ; lesdites compositions étant caractérisées en ce que l'entité cationique dudit borate de complexe organométallique est choisie parmi les sels organométalliques de formule
(L¹L²L³M)^{+q} (I)
formule dans laquelle :
. M représente un métal choisi parmi du fer, manganèse, chrome et cobalt,
. L¹ représente 1 ligand lié au métal M par des électrons π, ligand choisi parmi les ligands η³-alkyl, η⁵-cyclopentadiènyl et η⁷-cycloheptatriènyl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 3 à 8 électrons π ;
. L² représente 1 ligand lié au métal M par des électrons π, ligand choisi parmi les ligands η⁷-cydoheptatriènyl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 6 ou 7 électrons π ;
. L³ représente de 0 à 3 ligands identiques ou différents liés au métal M par des électrons σ, ligand(s) choisi(s) parmi CO et NO₂⁺ ;
la charge électronique totale q du complexe à laquelle contribuent L¹, L² et L³ et la charge ionique du métal M étant positive et égale à 1 ou 2 ;
et en ce que l'entité anionique borate a pour formule :
[B Xₐ R_{b}]⁻
formule dans laquelle :
- a et b sont des nombres entiers allant de 0 à 4 avec a + b = 4
- les symboles X représentent
. un atome de chlore ou de fluor avec a = 0 à 3
. une fonction OH avec a = 0 à 2
- les symboles R sont identiques ou différents et représentent
. un radical phényle substitué par au moins un élément ou un groupement électroattracteur choisi parmi un atome d'halogène, CF₃, NO₂, CN,
. un radical aryle contenant au moins deux noyaux aromatiques, éventuellement substitué par au moins un élément ou un groupement électroattracteur choisi parmi un atome d'halogène, CF₃, NO₂, CN.

2. Compositions selon la revendication 1 caractérisées en ce que le (ou les) atome(s) d'halogène, substituant(s) possible(s) de chaque radical R de l'anion borate, est (sont) du fluor.

3. Compositions selon la revendication 1 ou 2 caractérisées en ce que l'entité anionique borate est :
[B (C₆F₅)₄]⁻ ; [B (C₆H₄CF₃)₄]⁻ ;
[(C₆F₅)₂ B F₂]⁻ ; [C₆F₅ B F₃]⁻ ; [B (C₆H₃F₂)₄]⁻.

4. Compositions selon l'une quelconque des revendications 1 à 3 caractérisées en ce que l'entité cationique est:
. le (η⁵-cyclopentadiènyle) (η⁶-toluène) Fe⁺ ;
. le (η⁵-cyclopentadiènyle) (η⁶-méthyl1-naphtalène) Fe⁺ ;
. le (η⁵-cyclopentadiènyle) (η⁶-cuméne) Fe⁺ ;
. le bis (η⁶-mesitylène) Fe⁺ ;
. le bis (η⁶-benzène)Cr⁺.

5. Compositions selon l'une quelconque des revendications 1 à 4 caractérisées en ce que le borate de complexe organométallique est :
. le (η⁵-cyclopentadiènyle) (η⁶-toluène) Fe⁺, [B (C6 F5)₄]⁻;
. le (η⁵-cyclopentadiènyle) (η⁶-méthyl1-naphtalène) Fe⁺, [B (C₆F₅)₄]⁻.
. le (η⁵-cyclopentadiènyle) (η⁶-cumène) Fe⁺, [B (C₆F₅)₄]⁻.

6. Compositions selon l'une quelconque des revendications 1 à 5 caractérisées en ce que ledit polyorganosiloxane présente de 1 à 10 groupements époxyfonctionnels par mole de polymère.

7. Compositions selon l'une quelconque des revendications 1 à 6 caractérisées en ce que ledit polyorganosiloxane présente une viscosité à 25°C allant de 10 à 10.000 mm²/s.

8. Compositions selon l'une quelconque des revendications 1 à 7 caractérisées en ce que la quantité de borate de complexe organométallique est comprise entre 0,01 et 20 parties en poids pour 100 parties en poids de polyorganosiloxane réticulable.

9. Procédé pour rendre des articles non adhérents à des surfaces auxquelles ils adhéreraient normalement, caractérisé en ce qu'on applique entre 0,1 et 5 g par m² de surface dudit l'article à enduire de composition faisant l'objet de l'une quelconque des revendications 1 à 8 et on réticule ladite composition par voie photochimique ou sous faisceau d'électrons.

10. Procédé selon la revendication 9 caractérisé en ce que l'opération de réticulation est réalisée par un rayonnement U.V. de longueur d'onde allant de 200 à 400 namomètres.

11. Utilisation des compositions faisant l'objet de l'une quelconque des revendications 1 à 8, pour encapsuler les composants électriques et électroniques, revêtir les textiles, ainsi que pour gainer les fibres optiques.

## Patentansprüche

1. Zusammensetzungen auf Basis von:
• einem Polyorganosiloxan mit funktionellen Gruppen vom Epoxy-Typ, das auf kationischem Weg vernetzbar ist, wobei das Polyorganosiloxan linear oder im wesentlichen linear ist und aus Gruppierungen der Formel (II) besteht und beendet ist durch Gruppierungen der Formel (III) oder cyclisch ist, bestehend aus Gruppierungen der Formel (II) 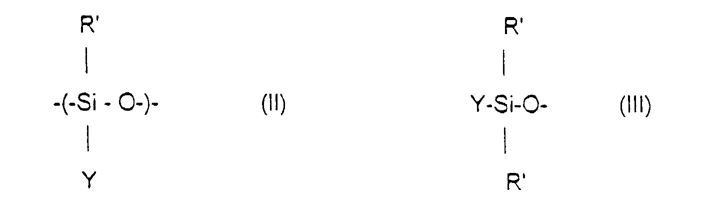 wobei
. in den Formeln die Symbole R' gleich oder verschieden sind und einen linearen oder verzweigten C₁-C₆ Alkylrest, der gegebenenfalls substituiert ist, C₅-C₈ Cycloalkyl, Aryl, substituiertes Aryl bedeuten, wobei zumindest 60 Mol% der Reste R' Methylreste sind;
. die Symbole Y gleich oder verschieden sind und entweder die Gruppe R' bedeuten oder einen auf kationischem Weg vernetzbaren funktionellen organischen Epoxyrest darstellen, wobei jede Epoxyfunktion an ein Atom der Silikonkette über einen zweiwertigen Rest mit 2 bis 20 Kohlenstoffatomen gebunden ist,
zumindest eines der Symbole Y einen auf kationischem Weg vernetzbaren funktionellen organischen Epoxyrest bedeutet, und
• einer katalytisch wirksamen Menge eines Borats eines organometallischen Komplexes, wobei die Zusammensetzungen dadurch gekennzeichnet sind, daß die kationische Einheit des Borats des organometallischen Komplexes ausgewählt ist unter den organometallischen Salzen der Formel
**(L**^{**1**}**L**^{**2**}**L**^{**3**}**M)**^{**+q**} **(I)**
worin:
. M ein Metall, ausgewählt unter Eisen, Mangan, Chrom und Kobalt bedeutet,
. L¹ 1 Liganden, gebunden an das Metall M durch π-Elektronen darstellt, wobei der Ligand ausgewählt ist unter den Liganden η³-Alkyl, η⁵-Cyclopentadienyl und η⁷-Cycloheptatrienyl und den η⁶-aromatischen Verbindungen, ausgewählt unter den η⁶-Benzolliganden, die gegebenenfalls substituiert sind, und den Verbindungen mit 2 bis 4 kondensierten Ringen, wobei jeder Ring imstande ist, zur Abdeckung der Valenz des Metalls M durch 3 bis 8 π-Elektronen beizutragen;
. L² 1 Liganden, der an das Metall M über π-Elektronen gebunden ist, bedeutet, wobei der Ligand ausgewählt ist unter den η⁷-Cycloheptatrienyl -Liganden und den η⁶-aromatischen Verbindungen, ausgewählt unter den η⁶ -Benzolliganden, die gegebenenfalls substituiert sind, und den Verbindungen mit 2 bis 4 kondensierten Ringen, wobei jeder Ring imstande ist, zur Abdeckung der Valenz des Metalls M durch 6 oder 7 π-Elektronen beizutragen;
. L³ 0 bis 3 gleiche oder verschiedene Liganden, die an das Metall M über σ-Elektronen gebunden sind, bedeutet, wobei der bzw. die Liganden unter CO und NO₂⁺ ausgewählt sind;
wobei die elektronische Gesamtladung q des Komplexes, zu der L¹, L² und L³ und die ionische Ladung des Metalls M beitragen, positiv ist und 1 oder 2 entspricht;
und daß die anionische Borateinheit die Formel:
**[B X**_{**a**} **R**_{**b**}**]**^{**-**}
besitzt, worin:
- a und b ganze Zahlen von 0 bis 4 sind mit a+b=4
- die Symbole X
. ein Chlor- oder Fluoratom mit a= 0 bis 3
. eine OH-Funktion mit a = 0 bis 2
bedeuten,
- die Symbole R identisch oder verschieden sind und die folgende Bedeutung besitzen:
. einen Phenylrest, substituiert durch zumindest ein Elektronen anziehendes Element oder eine Elektronen anziehende Gruppe, ausgewählt unter einem Halogenatom, CF₃, NO₂, CN,
. einen Arylrest mit zumindest zwei aromatischen Ringen, der gegebenenfalls substituiert ist durch zumindest ein Elektronen anziehendes Element oder eine Elektronen anziehende Gruppe, ausgewählt unter einem Halogenatom, CF₃, NO₂, CN.

2. Zusammensetzung gemäß Anspruch 1, dadurch gekennzeichnet, daß das oder die Halogenatom(e), der oder die mögliche(n) Substituent(en) eines jeden Restes R des Boratanions Fluor ist bzw. sind.

3. Zusammensetzungen gemäß Anspruch 1 oder 2, dadurch gekennzeichnet, daß die anionische Borateinheit ist:
**[B(C**_{**6**}**F**_{**5**}**)**_{**4**}**]- ; [B(C**_{**6**}**H**_{**4**}**CF**_{**3**}**)**_{**4**}**]**^{**-**}**;**
**[(C**_{**6**}**F**_{**5**}**)**_{**2**} **B F**_{**2**}**]**^{**-**} **; [C**_{**6**}**F**_{**5**} **B F**_{**3**}**]**^{**-**} **; [B(C**_{**6**}**H**_{**3**}**F**_{**2**}**)**_{**4**}**]**^{**-**}.

4. Zusammensetzungen gemäß einem der Ansprüche 1 bis 3, dadurch gekennzeichnet, daß die kationische Einheit ist:
. (η⁵ -Cyclopentadienyl) (η⁶-toluol) Fe⁺;
. (η⁵ -Cyclopentadienyl) (η⁶methyl-1-naphthalin) Fe⁺;
. (η⁵-Cyclopentadienyl) (η⁶-cumol) Fe⁺;
. Bis-(η⁶-mesitylen) Fe⁺;
. Bis-(η⁶-benzol) Cr⁺.

5. Zusammensetzungen gemäß einem der Ansprüche 1 bis 4, dadurch gekennzeichnet, daß das Borat des organometallischen Komplexes ist:
. (η⁵ -Cyclopentadienyl) (η⁶-toluol) Fe⁺, [B (C₆F₅)₄]⁻ ;
. (η⁵-Cyclopentadienyl) (η⁶methyl-1-naphthalin) Fe⁺, [B(C₆F₅)₄]⁻ ;
. (η⁵-Cyclopentadienyl) (η⁶-cumol) Fe⁺, [B(C₆F₅)₄)⁻.

6. Zusammensetzungen gemäß einem der Ansprüche 1 bis 5, dadurch gekennzeichnet, daß das Polyorganosiloxan 1 bis 10 epoxyfunktionelle Gruppen je Mol Polymeres aufweist.

7. Zusammensetzungen gemäß einem der Ansprüche 1 bis 6, dadurch gekennzeichnet, daß das Polyorganosiloxan eine Viskosität bei 25°C von 10 bis 10.000 mm²/s aufweist.

8. Zusammensetzungen gemäß einem der Ansprüche 1 bis 7, dadurch gekennzeichnet, daß die Menge an Borat des organometallischen Komplexes zwischen 0,01 und 20 Gew.-teilen je 100 Gew.-teile vernetzbares Polyorganosiloxan beträgt.

9. Verfahren, um Artikel an Oberflächen, an denen sie normalerweise haften würden, nicht-haftend zu machen, dadurch gekennzeichnet, daß man zwischen 0,1 und 5 g je m² der Oberfläche des mit der Zusammensetzung gemäß einem der Ansprüche 1 bis 8 zu überziehenden Artikels aufbringt, und die Zusammensetzung auf photochemischem Weg oder unter Elektronenstrahlung vernetzt.

10. Verfahren gemäß Anspruch 9, dadurch gekennzeichnet, daß das Vernetzungverfahren durch UV-Bestrahlung mit einer Wellenlänge von 200 bis 400 Nanometer erfolgt.

11. Verwendung der Zusammensetzungen gemäß einem der Ansprüche 1 bis 8 zur Einkapselung von elektrischen und elektronischen Komponenten, zum Beschichten von Textilien, sowie zur Umhüllung optischer Fasern.

## Claims

1. Compositions based:
. on a polyorganosiloxane exhibiting functional groups of epoxy type which can be crosslinked by the cationic route, the said polyorganosiloxane being linear or substantially linear and composed of units of formula (II) and terminated by units of formula (III) or cyclic and composed of units of formula (II) 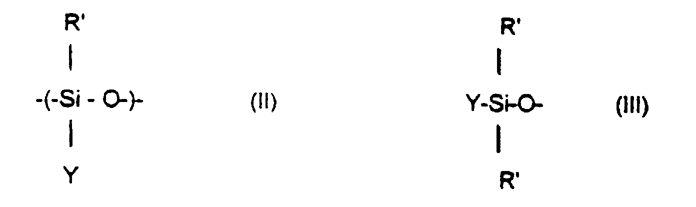 in which formulae
. the R' symbols are alike or different and represent a linear or branched C₁-C₆ alkyl radical which is optionally substituted, a C₅-C₈ cycloalkyl radical, an aryl radical or a substituted aryl radical, at least 60 molar % of the R' radicals being methyl radicals;
. the Y symbols are alike or different and represent either the R' group or a functional epoxy organic radical which can be crosslinked by the cationic route, each epoxy functional group being connected to an atom of the silicone chain via a divalent radical containing from 2 to 20 carbon atoms;
at least one of the Y symbols representing a functional epoxy organic radical which can be crosslinked by the cationic route, and
. on an effective catalytic amount of a borate of an organometallic complex; the said compositions being characterized in that the cationic entity of the said organometallic complex borate is chosen from organometallic salts of formula
(L¹L²L³M)^{+q} (I)
in which formula:
. M represents a metal chosen from iron, manganese, chromium and cobalt,
. L¹ represents a ligand bonded to the metal M via π electrons, the ligand being chosen from η³-alkyl, η⁵-cyclopentadienyl and η⁷-cycloheptatrienyl ligands and η⁶-aromatic compounds chosen from optionally substituted η⁶-benzene ligands and from compounds having from 2 to 4 condensed rings, each ring being capable of contributing to the valence layer of the metal M via 3 to 8 π electrons;
. L² represents a ligand bonded to the metal M via π electrons, the ligand being chosen from η⁷-cycloheptatrienyl ligands and η⁶-aromatic compounds chosen from optionally substituted η⁶-benzene ligands and from compounds having from 2 to 4 condensed rings, each ring being capable of contributing to the valence layer of the metal M via 6 or 7 π electrons;
. L³ represents from 0 to 3 identical or different ligands bonded to the metal M via σ electrons, (the) ligand(s) being chosen from CO and NO₂⁺;
the total electronic charge q of the complex to which L¹, L² and L³ contribute and the ionic charge of the metal M being positive and equal to 1 or 2;
and in that the anionic borate entity has the formula:
[BXₐR_{b}]⁻
in which formula:
- a and b are integers ranging from 0 to 4 with a+b=4
- the X symbols represent
. a chlorine or fluorine atom with a=0 to 3
. an OH functional group with a=0 to 2
- the R symbols are identical or different and represent
. a phenyl radical substituted by at least one electron-withdrawing element or group chosen from a halogen atom, CF₃, NO₂ or CN,
. an aryl radical containing at least two aromatic nuclei, optionally substituted by at least one electron-withdrawing element or group chosen from a halogen atom, CF₃, NO₂ or CN.

2. Compositions according to claim 1, characterized in that the halogen atom(s), (a) possible substituent(s) of each R radical of the borate anion, is (are) fluorine.

3. Compositions according to claim 1 or 2, characterized in that the anionic borate entity is:
[B(C₆F₅)₄]⁻ ; [B(C₆H₄CF₃)₄]⁻ ;
[(C₆F₅)₂BF₂]⁻ ; [C₆F₅BF₃]⁻ ; [B(C₆H₃F₂)₄]⁻.

4. Compositions according to any one of claims 1 to 3, characterized in that the cationic entity is:
. (η⁵-cyclopentadienyl) (η⁶-toluene) Fe⁺;
. (η⁵-cyclopentadienyl) (η⁶-1-methylnaphthalene) Fe⁺ ;
. (η⁵-cyclopentadienyl) (η⁶-cumene)Fe⁺ ;
. bis(η⁶-mesitylene)Fe⁺;
. bis (η⁶-benzene)Cr⁺.

5. Compositions according to any one of claims 1 to 4, characterized in that the organometallic complex borate is:
. (η⁵-cyclopentadienyl) (η⁶-toluene) Fe⁺ [B(C₆F₅)₄]⁻;
. (η⁵-cyclopentadienyl) (η⁶-1-methylnaphthalene) Fe⁺ [B(C₆F₅)₄)⁻ ;
. (η⁵-cyclopentadienyl) (η⁶-cumene)Fe⁺ [B(C₆F₅)₄]⁻.

6. Compositions according to any one of claims 1 to 5, characterized in that the said polyorganosiloxane exhibits from 1 to 10 epoxyfunctional groups per mole of polymer.

7. Compositions according to any one of claims 1 to 6, characterized in that the said polyorganosiloxane exhibits a viscosity at 25°C ranging from 10 to 10,000 mm²/s.

8. Compositions according to any one of claims 1 to 7, characterized in that the amount of organometallic complex borate is between 0.01 and 20 parts by weight per 100 parts by weight of crosslinkable polyorganosiloxane.

9. Process for making articles nonadherent to surfaces to which they would normally adhere, characterized in that between 0.1 and 5 g of composition forming the subject of any one of claims 1 to 8 is applied per m² of surface of the said article to be coated and the said composition is crosslinked photochemically or under an electron beam.

10. Process according to claim 9, characterized in that the crosslinking operation is carried out by U.V. radiation with a wavelength ranging from 200 to 400 nanometres.

11. Use of the compositions forming the subject of any one of claims 1 to 8 for encapsulating electrical and electronic components, for coating textiles and for sheathing optical fibres.
